# EUROPEAN PATENT APPLICATION

(11) **EP 4 517 833 A1**
(43) Date of publication of application: **05.03.2025**
(21) Application number: 23903116.4
(22) Date of filing: 23.10.2023
(51) Int. Cl.: H01L 29/78, H01L 29/12

(54) **SILICON CARBIDE MOSFET INVERTER CIRCUIT AND METHOD FOR CONTROLLING SILICON CARBIDE MOSFET INVERTER CIRCUIT**

(30) Priority: 16.12.2022 JP 2022201584
(71) Applicant: Fuji Electric Co., Ltd., Kawasaki-shi, Kanagawa 210-9530 (JP)
(72) Inventor: UTSUMI, Makoto, Kawasaki-shi, Kanagawa 210-9530 (JP)
(74) Representative: MERH-IP Matias Erny Reichl Hoffmann Patentanwälte PartG mbB
(86) International application number: PCT/JP2023/038187
(87) International publication number: WO 2024/127817

(57) **Abstract**

Provided is a silicon carbide MOSFET inverter circuit in which a first and second silicon carbide MOSFETs are connected in series, wherein: a current density of a transient current is less than 1000A/cm2 during a turn-off period of a to-be-controlled MOSFET; and a gate of the to-be-controlled MOSFET is turned on during the turn-off period such that a saturation current period is less than 5 µs. Provided is a control method of a silicon carbide MOSFET inverter circuit in which a first and second silicon carbide MOSFETs are connected in series, comprising: turning off a to-be-controlled MOSFET; and turning on a gate of the to-be-controlled MOSFET during a turn-off period of the to-be-controlled MOSFET such that a saturation current period is less than 5 µs, wherein a current density of a transient current is less than 1000A/cm2 during the turn-off period.

## Description

### BACKGROUND

### 1. TECHNICAL FIELD

The present invention relates to a silicon carbide MOSFET inverter circuit, and a control method for the silicon carbide MOSFET inverter circuit.

### 2. RELATED ART

Patent document 1 describes "a silicon carbide MOSFET inverter circuit capable of suppressing the expansion of stacking faults during deadtime".

### PRIOR ART DOCUMENT

### Patent document

Patent Document 1: Japanese patent No. 6977469
Patent Document 2: Japanese patent No. 6878802

### GENERAL DISCLOSURE

In a first aspect of the present invention, a silicon carbide MOSFET inverter circuit in which a first silicon carbide MOSFET and a second silicon carbide MOSFET are connected in series is provided, wherein: a current density of a transient current flowing in a built-in diode of a to-be-controlled MOSFET is less than 1000A/cm² during a turn-off period of the to-be-controlled MOSFET; a gate of the to-be-controlled MOSFET is turned on during the turn-off period such that a saturation current period in which the transient current becomes a saturation current is less than 5 µs; and the to-be-controlled MOSFET is the first silicon carbide MOSFET or the second silicon carbide MOSFET.

In the silicon carbide MOSFET inverter circuit, the to-be-controlled MOSFET includes: a drift region of a first conductivity type provided in a silicon carbide semiconductor substrate; a base region of a second conductivity type provided above the drift region in the semiconductor substrate; and a high concentration region of the second conductivity type having a higher doping concentration than the base region in the semiconductor substrate, wherein an area proportion of the high concentration region relative to an area of the drift region in a top view may be less than 50%.

In any silicon carbide MOSFET inverter circuit described above, the area proportion may be 44% or more and 48% or less.

In any silicon carbide MOSFET inverter circuit described above, the doping concentration of the high concentration region may be 4E18cm⁻³ or more and 1E19cm⁻³ or less.

In any silicon carbide MOSFET inverter circuit described above, the to-be-controlled MOSFET includes: a drift region of a first conductivity type provided in a silicon carbide semiconductor substrate; a base region of a second conductivity type provided above the drift region in the semiconductor substrate; a high concentration region of the second conductivity type having a higher doping concentration than the base region in the semiconductor substrate; a plurality of trench portions extending in a predetermined extending direction at a front surface side of the semiconductor substrate; and a plurality of contact regions of the second conductivity type having a higher doping concentration than the base region, respectively extending in the extending direction of the plurality of trench portions, between adjacent trench portions among the plurality of trench portions, wherein the high concentration region may include a plurality of first high concentration portions, respectively extending in the extending direction of the plurality of trench portions, below each of the plurality of trench portions.

In any silicon carbide MOSFET inverter circuit described above, the high concentration region may include a plurality of second high concentration portions, respectively extending in the extending direction of the plurality of trench portions, below each of the plurality of contact regions.

In any silicon carbide MOSFET inverter circuit described above, the high concentration region may include a plurality of third high concentration portions extending in a stripe shape traversing the plurality of first high concentration portions and the plurality of second high concentration portions in an arrangement direction of the plurality of trench portions.

In any silicon carbide MOSFET inverter circuit described above, a separation distance between third high concentration portions that are adjacent in the extending direction of the plurality of trench portions among the plurality of third high concentration portion provided in the stripe shape may be 24 µm or more and 40 µm or less.

In any silicon carbide MOSFET inverter circuit described above, an area proportion of the high concentration region relative to an area of the drift region in a top view may be less than 50%.

In any silicon carbide MOSFET inverter circuit described above, the doping concentration of the high concentration region may be 4E18cm⁻³ or more and 1E19cm⁻³ or less.

In any silicon carbide MOSFET inverter circuit described above, the to-be-controlled MOSFET includes: a drift region of a first conductivity type provided in a silicon carbide semiconductor substrate; a base region of a second conductivity type provided above the drift region in the semiconductor substrate; a high concentration region of the second conductivity type having a higher doping concentration than the base region in the semiconductor substrate; a plurality of trench portions extending in a predetermined extending direction at a front surface side of the semiconductor substrate; and a plurality of contact regions of the second conductivity type having a higher doping concentration than the base region, arranged in an island shape spaced apart from each of adjacent trench portions, between the adjacent trench portions among the plurality of trench portions, wherein the high concentration region may include a plurality of first high concentration portions, respectively extending in the extending direction, below each of the plurality of trench portions.

In any silicon carbide MOSFET inverter circuit described above, each of the plurality of contact regions may be provided in contact with each of first high concentration portions provided below each of the adjacent trench portions among the plurality of first high concentration portions.

In any silicon carbide MOSFET inverter circuit described above, a separation distance between contact regions that are adjacent in the extending direction of the plurality of trench portions among the plurality of contact regions may be 2 µm or more and 4 µm or less.

In any silicon carbide MOSFET inverter circuit described above, an area proportion of the high concentration region relative to an area of the drift region in a top view may be less than 50%.

In any silicon carbide MOSFET inverter circuit described above, the area proportion may be 44% or more and 48% or less.

Any silicon carbide MOSFET inverter circuit described above may include a first diode connected to the first silicon carbide MOSFET in an anti-parallel manner, and a second diode connected to the second silicon carbide MOSFET in an anti-parallel manner.

In any silicon carbide MOSFET inverter circuit described above, a bus voltage applied to the to-be-controlled MOSFET may be 2/3 or less of a breakdown voltage of the to-be-controlled MOSFET.

In a second aspect of the present invention, a control method of a silicon carbide MOSFET inverter circuit in which a first silicon carbide MOSFET and a second silicon carbide MOSFET are connected in series is provided, the control method of the silicon carbide MOSFET inverter circuit comprising: turning off a to-be-controlled MOSFET; and turning on a gate of the to-be-controlled MOSFET during a turn-off period of the to-be-controlled MOSFET such that a saturation current period in which a transient current flowing in a built-in diode of the to-be-controlled MOSFET becomes a saturation current is less than 5 µs, wherein during the turn-off period, a current density of the transient current is less than 1000A/cm², and the to-be-controlled MOSFET is the first silicon carbide MOSFET or the second silicon carbide MOSFET.

The summary clause does not necessarily describe all necessary features of the embodiments of the present invention. The invention may also include a sub-combination of the features described above.

### BRIEF DESCRIPTION OF THE DRAWINGS

Fig. 1 shows an example of a silicon carbide MOSFET inverter circuit 100.
Fig. 2A shows an example of a temporal change of a drain-source voltage Vds of a to-be-controlled MOSFET 20.
Fig. 2B shows an enlarged drawing of a region S in Fig. 2A.
Fig. 3 shows an example of a temporal change of a current flowing in a built-in diode of the to-be-controlled MOSFET 20.
Fig. 4 shows an example of an on-voltage rising rate ΔVon of the to-be-controlled MOSFET 20 with respect to a length of a saturation current period.
Fig. 5A shows an example of an upper surface of the to-be-controlled MOSFET 20.
Fig. 5B shows an example of a cross section including a high concentration region 230 of the to-be-controlled MOSFET 20.
Fig. 5C shows an example of a cross section A-A' in Fig. 5A.
Fig. 5D shows an example of a cross section B-B' in Fig. 5A.
Fig. 6A shows a modified example of an upper surface of the to-be-controlled MOSFET 20.
Fig. 6B shows a modified example of a cross section including a high concentration region 230 of the to-be-controlled MOSFET 20.
Fig. 6C shows an example of a cross section C-C' in Fig. 6A.
Fig. 6D shows an example of a cross section D-D' in Fig. 6A.
Fig. 7 shows an example of a flowchart of a control method of a silicon carbide MOSFET inverter circuit 100.

### DESCRIPTION OF EXEMPLARY EMBODIMENTS

Hereinafter, the present invention will be described through embodiments of the invention, but the following embodiments do not limit the invention according to the claims. In addition, not all of the combinations of features described in the embodiments are essential to the solution of the invention.

In the present specification, one side in a direction parallel to a depth direction of a semiconductor substrate is referred to as an "upper" side, and the other side is referred to as a "lower" side. One surface of two principal surfaces of a substrate, a layer or other member is referred to as an upper surface, and another surface is referred to as a lower surface. Directions of "upper", "lower", "front", and "back" are not limited to direction of gravity, or a direction of mounting on a substrate or the like in implementation of a silicon carbide MOSFET inverter circuit.

In the present specification, technical matters may be described using orthogonal coordinate axes of the X axis, the Y axis, and the Z axis. As used herein, an XY plane refers to a plane parallel to an upper surface of the semiconductor substrate, and the Z axis refers to a depth direction of the semiconductor substrate.

Each example embodiment shows an example in which a first conductivity type is set as an N type, and a second conductivity type is set as a P type; however, the first conductivity type may be the P type, and the second conductivity type may be the N type. In this case, conductivity types of the substrate, the layer, a region, and the like in each example embodiment respectively have opposite polarities.

In the present specification, in a layer or a region specified with N or P, electrons or holes are meant to be majority carriers, respectively. The sign "+" or "-" given to the character "N" or "P" means having a higher or lower doping concentration than layers or regions without it, respectively.

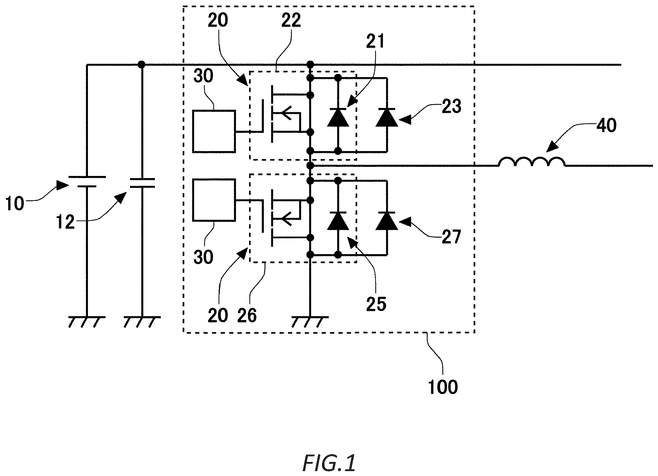

Fig. 1 shows an example of a silicon carbide MOSFET inverter circuit 100. The silicon carbide MOSFET inverter circuit 100 includes a first silicon carbide MOSFET 22, a second silicon carbide MOSFET 26, and a control circuit 30. The silicon carbide MOSFET inverter circuit 100 may include a first diode 23 and a second diode 27. The silicon carbide MOSFET inverter circuit 100 may be connected to a direct current power source 10, a smoothing capacitor 12, and a load 40. As the silicon carbide MOSFET inverter circuit 100, an H-bridge may be provided by two sets of silicon carbide MOSFET inverter circuits 100 connected in parallel to the load 40. In addition, a three-phase inverter may be provided by three sets of silicon carbide MOSFET inverter circuits 100 connected in parallel.

The silicon carbide MOSFET inverter circuit 100 is an inverter circuit in which the first silicon carbide MOSFET 22 and the second silicon carbide MOSFET 26 are connected in series. The silicon carbide MOSFET inverter circuit 100 may be an inverter circuit in which a DC voltage applied from the direct current power source 10 is converted into an AC voltage. The DC voltage of the direct current power source 10 may be input to the silicon carbide MOSFET inverter circuit 100 after being smoothed by the smoothing capacitor 12. The AC voltage converted to by the silicon carbide MOSFET inverter circuit 100 may be applied to the load 40.

The first silicon carbide MOSFET 22 includes a first built-in diode 21. The first built-in diode 21 may be a parasitic diode formed between a source electrode and a drain electrode due to a configuration of the first silicon carbide MOSFET 22.

The first diode 23 is connected to the first silicon carbide MOSFET 22 in an anti-parallel manner. The first diode 23 may be a Schottky barrier diode. The first diode 23 may shunt the current flowing in the first built-in diode 21 at the time of regeneration of the first silicon carbide MOSFET 22, or may cause the current not to flow in the first built-in diode 21. By providing the first diode 23, expansion of stacking faults generated by the current flowing in the first built-in diode 21 at the time of regeneration of the first silicon carbide MOSFET 22 can be suppressed, and a rise of an on-resistance and a rise of an on-voltage of the first silicon carbide MOSFET 22 can be suppressed.

The second silicon carbide MOSFET 26 includes a second built-in diode 25. The second built-in diode 25 may be a parasitic diode formed between a source electrode and a drain electrode due to the second silicon carbide MOSFET 26.

The second diode 27 is connected to the second silicon carbide MOSFET 26 in an anti-parallel manner. The second diode 27 may be a Schottky barrier diode. The second diode 27 may shunt the current flowing in the second built-in diode 25 at the time of regeneration of the second silicon carbide MOSFET 26, or may cause the current not to flow in the second built-in diode 25. By providing the second diode 27, expansion of stacking faults generated by the current flowing in the second built-in diode 25 at the time of regeneration of the second silicon carbide MOSFET 26 can be suppressed, and a rise of an on-resistance and a rise of an on-voltage of the second silicon carbide MOSFET 26 can be suppressed.

In the following description, a MOSFET that is a to-be-controlled object upon operation of the inverter circuit is referred to as a to-be-controlled MOSFET 20. That is, the to-be-controlled MOSFET 20 is the first silicon carbide MOSFET 22 or the second silicon carbide MOSFET 26.

The control circuit 30 controls on/off of the to-be-controlled MOSFET 20 by applying a gate voltage to the to-be-controlled MOSFET 20. In addition, a bus voltage is applied from the direct current power source 10 to the to-be-controlled MOSFET 20. A bus voltage applied to the to-be-controlled MOSFET 20 upon a normal operation may be 2/3 or less of a breakdown voltage of the to-be-controlled MOSFET 20. In Fig. 1, the control circuit 30 is provided to each of the first silicon carbide MOSFET 22 and the second silicon carbide MOSFET 26, but not limited thereto. That is, a control circuit 30 may be integrally provided as long as it is a circuit that is capable of controlling each of the first silicon carbide MOSFET 22 and the second silicon carbide MOSFET 26.

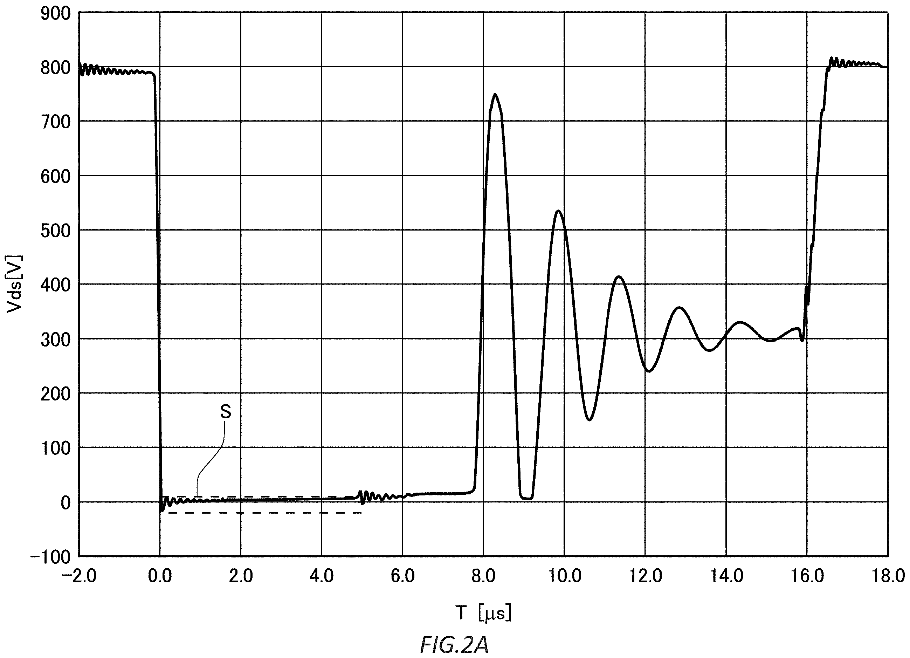

Fig. 2A shows an example of a temporal change of a drain-source voltage Vds of a first silicon carbide MOSFET 22. The horizontal axis indicates time T, and the vertical axis indicates a drain-source voltage Vds of the first silicon carbide MOSFET 22. A breakdown voltage of the to-be-controlled MOSFET 20 in the present example is 1200V, and a bus voltage is 800V. That is, the bus voltage applied to the to-be-controlled MOSFET 20 of the present example is 2/3 of the breakdown voltage of the to-be-controlled MOSFET 20.

The first silicon carbide MOSFET 22 to which the bus voltage of 800V is applied is in an ON state before a time T = 0 µs. The second silicon carbide MOSFET 26 is in an OFF state before the time T = 0 µs. In the time T = 0 µs, a current is applied to the second built-in diode 25 of the second silicon carbide MOSFET 26 by turning off the first silicon carbide MOSFET 22, and the second built-in diode 25 is in an energized state until a time T = 7.5 µs. In a time T = 2.0 µs, a gate voltage is applied to the second silicon carbide MOSFET 26, to turn on the second silicon carbide MOSFET 26. In the time T = 7.5 µs, by stopping the application of the gate voltage by the control circuit 30 to the second silicon carbide MOSFET 26, the second silicon carbide MOSFET 26 is turned into the OFF state. Then, in a time T = 16.5 µs, the bus voltage is applied by the control circuit 30 again, to put the first silicon carbide MOSFET 22 into the ON state. These operations may be repeated for each 40 µs.

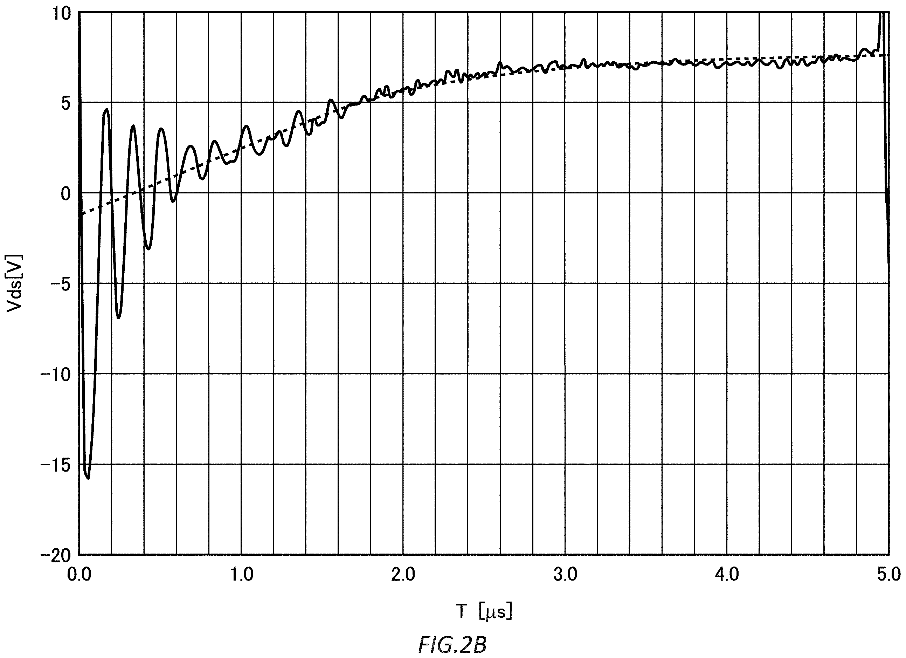

Fig. 2B shows an enlarged drawing of a region S in Fig. 2A. Fig. 2B is an enlarged drawing of a range from the time T = 0 µs to the time T = 5 µs. Dashed lines of Fig. 2B indicate approximate curves of the drain-source voltage Vds. By a transient current flowing in the second built-in diode 25 of the second silicon carbide MOSFET 26 at the time T = 0 µs, the second built-in diode 25 is put into an energized state.

During energizing the second built-in diode 25, a conductivity modulation occurs due to holes injected into an energized portion and the drain-source voltage Vds gradually rises. The gradual voltage rising from T = 0 µs to T = 5 µs in Fig. 2B indicates that an injection amount of holes gradually increases and electroconductivity gradually decreases. Then, when the injection amount of holes becomes a certain amount or more, the conductivity modulation is saturated, and the drain-source voltage Vds in the OFF state is saturated. Fig. 2B indicates that the drain-source voltage Vds is saturated at the time T = 5 µs. That is, until the time T = 5 µs, an amount of holes injected in the second silicon carbide MOSFET 26 is less compared to that of a case after the time T = 5 µs.

In a silicon carbide MOSFET, when there is a defect in a crystal of a semiconductor substrate, holes are injected, and electrons and the holes in the semiconductor substrate are recombined if a current is flowing in a built-in diode. By recombining energy generated at this time, stacking fault is expanded, which is a kind of crystal defect present in a silicon carbide semiconductor substrate. Accordingly, until the time T = 5 µs, because the amount of holes injected into the second silicon carbide MOSFET 26 is less compared to that of a case after the time T = 5 µs, a frequency of occurrence of recombining of the electrons and the holes is lower, and the expansion of the stacking fault is smaller.

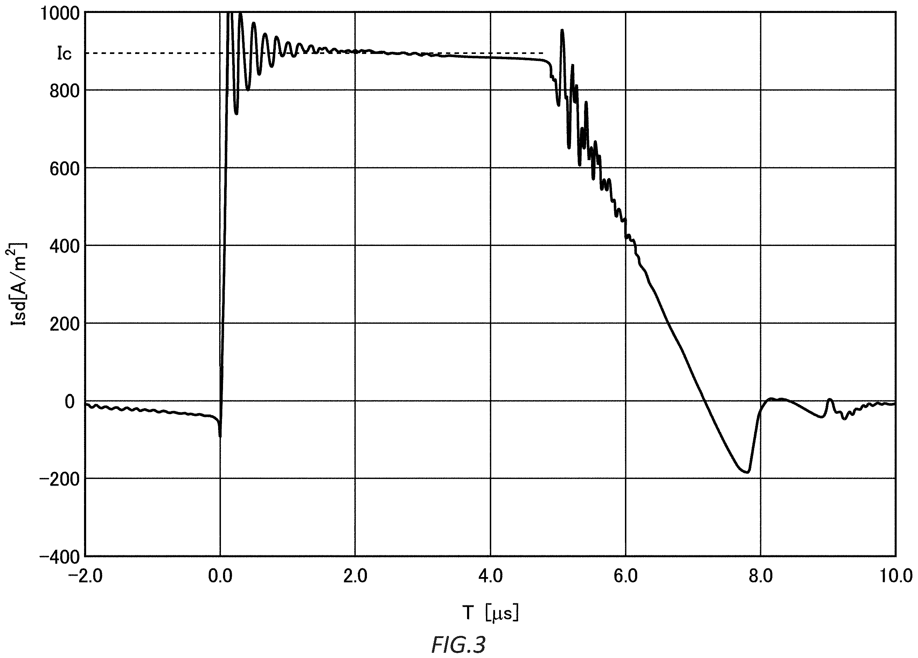

Fig. 3 shows an example of a temporal change of a current flowing in a second built-in diode 25 of the second silicon carbide MOSFET 26. The horizontal axis indicates time T, and the vertical axis indicates a current flowing in the second built-in diode 25 of the second silicon carbide MOSFET 26. The time T in Fig. 3 corresponds to the time T in Fig. 2A and Fig. 2B. That is, in the time T = 0 µs, the first silicon carbide MOSFET 22 switches into the OFF state.

In the time T = 0 µs, a transient current starts to flow in the second built-in diode 25, and the transient current becomes a saturation current Ic. During a turn-off period of the first silicon carbide MOSFET 22, a current density of the transient current flowing in the second built-in diode 25 of the second silicon carbide MOSFET 26 may be less than 1000A/cm². That is, the current density of the saturation current Ic may be less than 1000A/cm². As an example, the current density of the saturation current Ic is 900A/cm². Hereinabove, an operation of the second silicon carbide MOSFET 26 and the second built-in diode 25 during the turn-off period of the first silicon carbide MOSFET 22 is described, but the first silicon carbide MOSFET 22 and the first built-in diode 21 during a turn-off period of the second silicon carbide MOSFET 26 operates in a similar cycle except for a phase of on/off being shifted by 90 degrees. In this manner, during a turn-off period of the to-be-controlled MOSFET, the current density of the transient current flowing in the built-in diode of the to-be-controlled MOSFET may be less than 1000A/cm². That is, during the turn-off period of the first silicon carbide MOSFET 22, a current density of the transient current flowing in the second built-in diode 25 of the second silicon carbide MOSFET 26 may be less than 1000A/cm², and during the turn-off period of the second silicon carbide MOSFET 26, the current density of the transient current flowing in the first built-in diode 21 of the first silicon carbide MOSFET 22 may be less than 1000A/cm².

The control circuit 30 turns on a gate of the to-be-controlled MOSFET 20 during the turn-off period of the to-be-controlled MOSFET 20 such that a saturation current period in which a transient current becomes a saturation current Ic is less than 5 µs. The control circuit 30 of the present example turns on the gate of the to-be-controlled MOSFET 20 at the time T = 5 µs. The saturation current period of the present example is a period from T > 0 µs to T = 5 µs, and less than 5 µs. By turning on the gate of the to-be-controlled MOSFET 20, a current can flow on a channel side, and a current flowing in the built-in diode can be reduced. In the example of Fig. 3, from the time T = 5 µs to time T = 8 µs, the current flowing in the built-in diode is reduced. In this manner, during the turn-off period of the to-be-controlled MOSFET 20, turning on the gate of the to-be-controlled MOSFET 20 to control the current flowing in the built-in diode to be reduced is referred to as a synchronization control.

By performing the synchronization control on the to-be-controlled MOSFET 20, an expansion of stacking faults of the to-be-controlled MOSFET 20 can be suppressed. That is, by performing the synchronization control on the to-be-controlled MOSFET 20 to cause the saturation current period in which the transient current becomes the saturation current Ic to be less than 5 µs, the current flowing in the built-in diode during a period in which an amount of holes injected in the to-be-controlled MOSFET 20 is small can be reduced, and the frequency of recombining the electrons and the holes can be reduced to suppress the expansion of the stacking faults. Furthermore, by suppressing the expansion of the stacking faults, a rise of an on-resistance and a rise of an on-voltage of the to-be-controlled MOSFET 20 can be suppressed, and a failure of the to-be-controlled MOSFET 20 can be reduced.

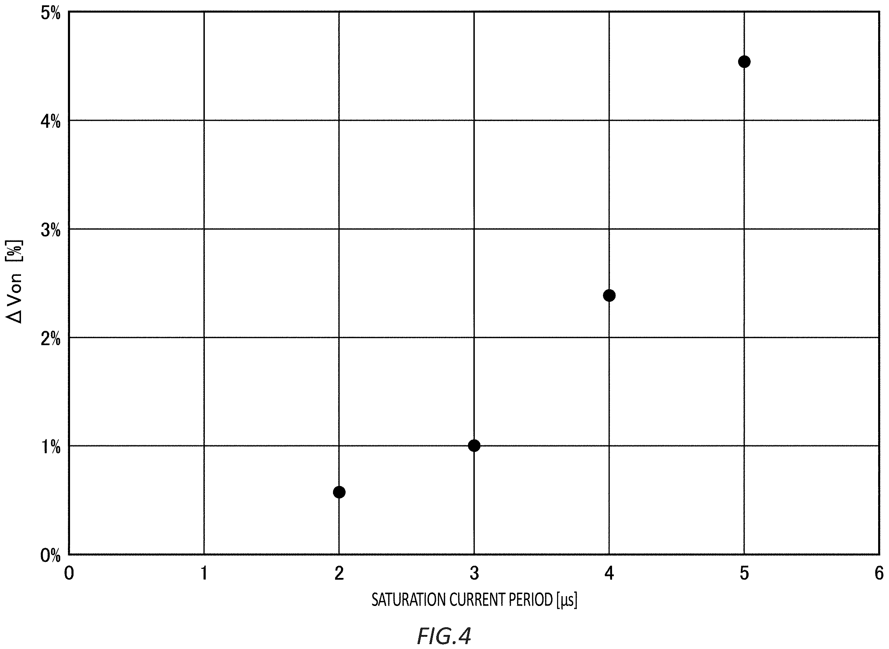

Fig. 4 shows an example of an on-voltage rising rate ΔVon of the to-be-controlled MOSFET 20 with respect to a length of a saturation current period. The vertical axis indicates a rising rate with respect to an initial state of the on-voltage of the on-voltage after operating the to-be-controlled MOSFET 20 for predetermined number of times, and the horizontal axis indicates a length of the saturation current period when the to-be-controlled MOSFET 20 is operated for the predetermined number of times. That is, on-voltage rising rates ΔVon are indicated, each of which is in cases in which the to-be-controlled MOSFET 20 is operated for predetermined number of times such that the length of the saturation current period is 2 µs, 3 µs, 4 µs, or 5 µs. The on-voltage rising rate ΔVon of the to-be-controlled MOSFET 20 is saturated if the to-be-controlled MOSFET 20 is operated for a certain number of times or more. The predetermined number of times in Fig. 4 is the certain number of times or more, and the on-voltage rising rate ΔVon is a saturated value.

As shown in Fig. 4, by performing a synchronization control on the to-be-controlled MOSFET 20 such that the saturation current period is less than 5 µs, the failure of the to-be-controlled MOSFET 20 can be reduced. That is, the on-voltage rising rate ΔVon of the to-be-controlled MOSFET 20 is less than 5% that is a reference of determining the failure.

In order to suppress the expansion of the stacking faults, restrictions may be applied on a current density of a transient current and a pulse width of a transient current. By performing the synchronization control during the turn-off period of the to-be-controlled MOSFET 20, the silicon carbide MOSFET inverter circuit 100 of the present example can relax these restrictions and can reduce a constraint upon driving the silicon carbide MOSFET inverter circuit 100. Furthermore, by increasing a current density of the current flowing in the built-in diode and/or extending a period during which the current flow in the built-in diode, an amount of current used for regeneration of the to-be-controlled MOSFET 20 can be increased, and an efficiency of regeneration of the to-be-controlled MOSFET 20 can be increased.

In addition, in order to suppress the expansion of the stacking faults, a diode that is connected to the to-be-controlled MOSFET 20 in an anti-parallel manner, for example, the first diode 23 and the second diode 27 in Fig. 1, may be provided. That is, by providing such a diode, the current flowing in the built-in diode at the time of regeneration of the to-be-controlled MOSFET 20 may be suppressed. According to the present example embodiment, by performing the synchronization control on the to-be-controlled MOSFET 20 to cause the saturation current period in which the transient current becomes the saturation current Ic to be less than 5 µs, the current flowing in the built-in diode during a period in which an amount of holes injected in the to-be-controlled MOSFET 20 is small can be reduced, and therefore the first diode 23 and the second diode 27 are not necessarily required to be provided. That is, the silicon carbide MOSFET inverter circuit 100 of the present example may not include the first diode 23 and the second diode 27.
If the first diode 23 and the second diode 27 are not provided, the silicon carbide MOSFET inverter circuit 100 can be miniaturized and inexpensive.

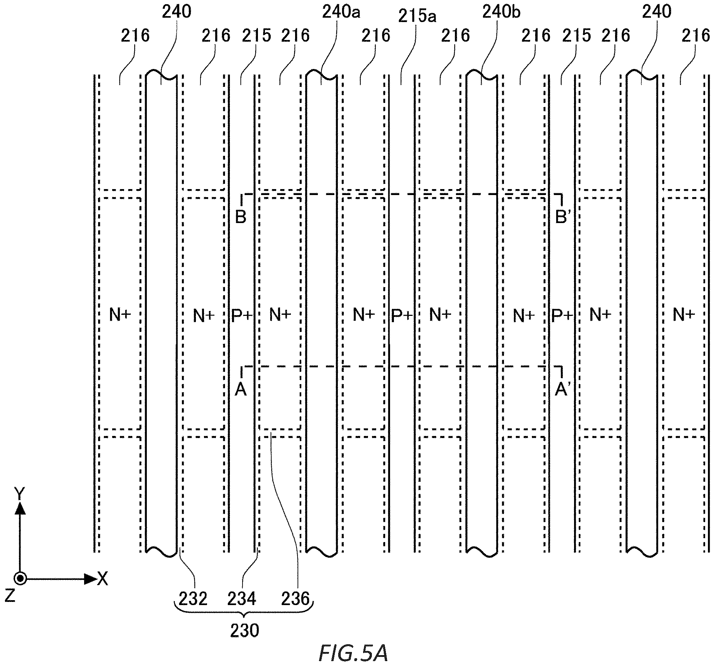

Fig. 5A shows an example of an upper surface of the to-be-controlled MOSFET 20. The to-be-controlled MOSFET 20 includes a contact region 215, a source region 216, and a trench portion 240 on a front surface of a silicon carbide semiconductor substrate 210. The to-be-controlled MOSFET 20 includes a high concentration region 230 below the front surface of the silicon carbide semiconductor substrate 210. That is, the high concentration region 230 is indicated with dashed lines because it is not exposed on the front surface of the silicon carbide semiconductor substrate 210. The high concentration region 230 includes a first high concentration portion 232, a second high concentration portion 234, and a third high concentration portion 236.

The to-be-controlled MOSFET 20 includes a plurality of trench portions 240 extending in a predetermined extending direction on the front surface of the semiconductor substrate 210. The extending direction of the trench portion 240 of the present example is a Y axis direction.

The to-be-controlled MOSFET 20 includes a plurality of contact regions 215 of a second conductivity type, respectively extending in the extending direction of the plurality of trench portions 240, between adjacent trench portions among the plurality of trench portions 240. As an example, a contact region 215a among the plurality of contact regions 215 is extending, between adjacent trench portions 240a and 240b among the plurality of trench portions 240, in the Y axis direction. The contact region 215 is of P+ type, as an example.

The high concentration region 230 is a region of the second conductivity type. The high concentration region 230 may be a region that functions as a hole injection path.

The high concentration region 230 includes a plurality of first high concentration portions 232 respectively extending in the extending direction of the plurality of trench portions 240, below each of the plurality of trench portions 240. In the present example, the first high concentration portion 232 extends in the Y axis direction that is the extending direction of the trench portion 240.

The high concentration region 230 includes a plurality of second high concentration portions 234 respectively extending in the extending direction of the plurality of trench portions 240, below each of the plurality of contact regions 215. In the present example, the second high concentration portion 234 extends in the Y axis direction that is the extending direction of the trench portion 240.

The high concentration region 230 includes a plurality of third high concentration portions 236 extending in a stripe shape by traversing the plurality of first high concentration portions 232 and the plurality of second high concentration portions 234 in an arrangement direction of the plurality of trench portions 240. The arrangement direction of the plurality of trench portions 240 of the present example is an X axis direction, and the third high concentration portion 236 extends in a stripe shape by traversing the plurality of first high concentration portions 232 and the plurality of second high concentration portions 234 in the X axis direction that is the arrangement direction of the plurality of trench portions 240. The third high concentration portion 236 may be provided as a bridge for conducting the plurality of first high concentration portions 232 and the plurality of second high concentration portions 234.

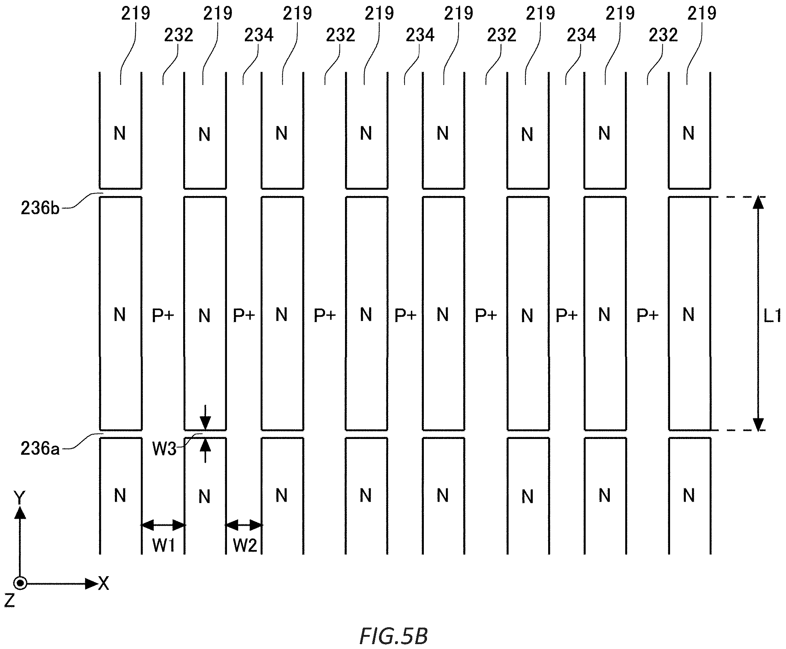

Fig. 5B shows an example of a cross section including a high concentration region 230 of the to-be-controlled MOSFET 20. That is, an example of a cross section of a plane including the region indicated with the dashed lines in Fig. 5A is indicated. The to-be-controlled MOSFET 20 includes a second drift region 219, which is described below, in the plane including the high concentration region 230.

A width W1 of the first high concentration portion 232 may be 0.7 µm or more, and 1.1 µm or less. As an example, the width W1 of the first high concentration portion 232 is 0.9 µm.

A width W2 of the second high concentration portion 234 may be 0.55 µm or more, and 0.95 µm or less. As an example, the width W2 of the second high concentration portion 234 is 0.75 µm.

A separation distance between the third high concentration portions 236 that are adjacent in the extending direction of the plurality of trench portions 240 among the plurality of third high concentration portions 236 provided in the stripe shape may be 24 µm or more and 40 µm or less. That is, a separation distance L1 between third high concentration portion 236a and 236b that are adjacent in the Y axis direction that is the extending direction of the trench portion 240 among the plurality of third high concentration portions 236 may be 24 µm or more and 40 µm or less. As an example, the separation distance L1 is 32 µm. A width W3 of the third high concentration portion 236 may be 0.8 µm or more, and 1.2 µm or less. As an example, the width W3 of the third high concentration portion 236 is 1.0 µm.

In a top view, an area proportion of the high concentration region 230 relative to an area of a drift region 217 may be less than 50%. That is, a ratio of the area of the high concentration region 230 occupying on the area of the region shown in Fig. 5B may be less than 50%. The drift region 217 will be described below.

By setting the width W1 of the first high concentration portion 232, the width W2 of the second high concentration portion 234, a width W4 of the third high concentration portion 236, and the separation distance L1 between the third high concentration portions 236 as described above, the area proportion of the high concentration region 230 relative to the area of the drift region 217 can be less than 50%.

By causing the area proportion of the high concentration region 230 relative to the area of the drift region 217 to be less than 50%, a hole injection amount during a period in which a current is flowing in the built-in diode can be suppressed. That is, by causing the area proportion of the high concentration region 230 of a second conductivity type which is a factor of hole injection to be less than 50%, a hole injection amount during a period in which a current is flowing in the built-in diode can be suppressed. If the hole injection amount during the period in which the current is flowing in the built-in diode is reduced, the frequency of recombining electrons and holes is reduced, and an expansion of stacking faults can be suppressed. Furthermore, by suppressing the expansion of the stacking faults, a rise of an on-resistance and a rise of an on-voltage of the to-be-controlled MOSFET 20 can be suppressed, and a failure of the to-be-controlled MOSFET 20 can be reduced.

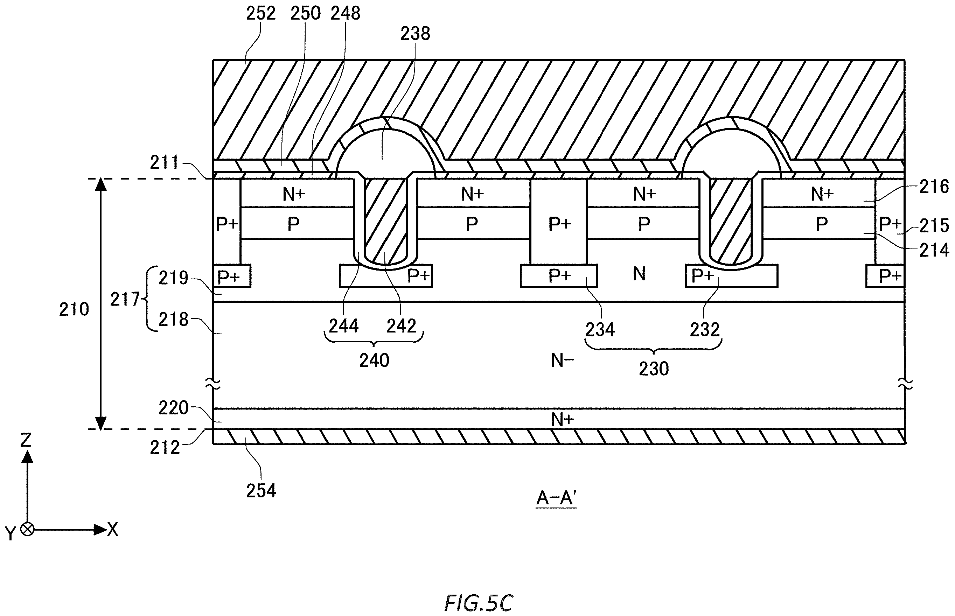

Fig. 5C shows an example of a cross section A-A' in Fig. 5A. The to-be-controlled MOSFET 20 includes a base region 214, the contact region 215, the source region 216, the drift region 217, a buffer region 220, the high concentration region 230, and the trench portion 240 in the silicon carbide semiconductor substrate 210. The to-be-controlled MOSFET 20 includes a dielectric film 238, a contact electrode 248, a barrier metal 250, and a source electrode 252 above the semiconductor substrate 210. The to-be-controlled MOSFET 20 includes a drain electrode 254 below the semiconductor substrate 210.

The buffer region 220 is a region of a first conductivity type which is provided on a back surface 212 of the semiconductor substrate 210. The buffer region 220 is of N+ type, as an example.

The drift region 217 includes a first drift region 218, and a second drift region 219. The first drift region 218 is a region of the first conductivity type provided above the buffer region 220. The first drift region 218 is of N- type, as an example. The doping concentration of the first drift region 218 may be lower than the doping concentration of the buffer region 220. The second drift region 219 is a region of the first conductivity type provided above the first drift region 218. The second drift region 219 is of N type, as an example. The doping concentration of the second drift region 219 may be higher than the doping concentration of the first drift region 218, and may be lower than the doping concentration of the buffer region 220.

The base region 214 is a region of the second conductivity type provided above the drift region 217. The base region 214 is of the P type, as an example.

The doping concentration of the contact region 215 is higher than the doping concentration of the base region 214. The contact region 215 is of P+ type, as an example.

The source region 216 is a region of the first conductivity type provided above the base region 214. The source region 216 is of N+ type, as an example. The doping concentration of the source region 216 may be higher than the doping concentration of the drift region 217.

The doping concentration of the high concentration region 230 is higher than the doping concentration of the base region 214. The doping concentration of the high concentration region 230 may be 4E18cm⁻³ or more and 1E19cm⁻³ or less. As an example, the doping concentration of the high concentration region 230 is 7E18cm⁻³.

In a top view, an area proportion of the high concentration region 230 relative to an area of a drift region 217 may be less than 50%, but not limited thereto. In response to the doping concentration of the high concentration region 230, the area proportion of the high concentration region 230 can be set with a value by which the hole injection amount is suppressed. In addition, the area proportion of the high concentration region 230 can be accordingly set in response to the doping concentration of the base region 214, the contact region 215, the source region 216, the drift region 217, or the like. That is, in response to the doping concentration of the high concentration region 230, the width W1 of the first high concentration portion 232, the width W2 of the second high concentration portion 234, the width W4 of the third high concentration portion 236, and the separation distance L1 of the third high concentration portion 236 may be respectively set with a value by which the hole injection amount is suppressed, or may be set in response to the doping concentration of the base region 214, the contact region 215, the source region 216, the drift region 217, or the like.

The trench portion 240 may be provided to pass through the source region 216 and the base region 214 to reach the second drift region 219. A configuration in which the trench portion 240 passes through the source region 216 and the base region 214 is not limited to a configuration that is manufactured in the order in which the source region 216 and the base region 214 are formed and then the trench portion 240 is formed. A configuration that is manufactured in the order in which the trench portion 240 is formed and then the source region 216 and the base region 214 are formed on a side wall of the trench portion 240 is included in the configuration in which the trench portion 240 passes through the source region 216 and the base region 214.

The trench portion 240 includes a gate conductive portion 242 and a gate dielectric film 244. The gate dielectric film 244 is formed to cover an inner wall of the trench portion 240.
The gate dielectric film 244 may be formed by oxidizing a semiconductor on the inner wall of the trench portion 240. The gate conductive portion 242 is formed closer to an inner side than the gate dielectric film 244 within the trench portion 240. The gate dielectric film 244 insulates the gate conductive portion 242 from the semiconductor substrate 210. The gate conductive portion 242 is formed of a conductive material such as polysilicon. The trench portion 240 is covered by the dielectric film 238 on a front surface 211 of the semiconductor substrate 210.

The contact electrode 248 is provided above the contact region 215 on the front surface 211 of the semiconductor substrate 210. The contact electrode 248 may be a silicide layer formed by a heating process after the deposit of a metal thin film. As an example, the material of the contact electrode 248 includes nickel silicide. The contact electrode 248 may reduce a contact resistance between the source electrode 252 and the semiconductor substrate 210.

The barrier metal 250 is provided to cover the dielectric film 238 and the contact electrode 248. The material of the barrier metal 250 may contain titanium or titanium nitride.

The source electrode 252 is provided above the semiconductor substrate 210 with the dielectric film 238 interposed therebetween. The source electrode 252 is formed of a material containing metal. At least a partial region of the source electrode 252 may be formed of a metal such as aluminum, or a metal alloy such as aluminum-silicon alloy (Alsi) or aluminum-silicon-copper alloy (AlSiCu).

The drain electrode 254 is formed on the back surface 212 of the semiconductor substrate 210. The drain electrode 254 is formed of a conductive material such as metal.

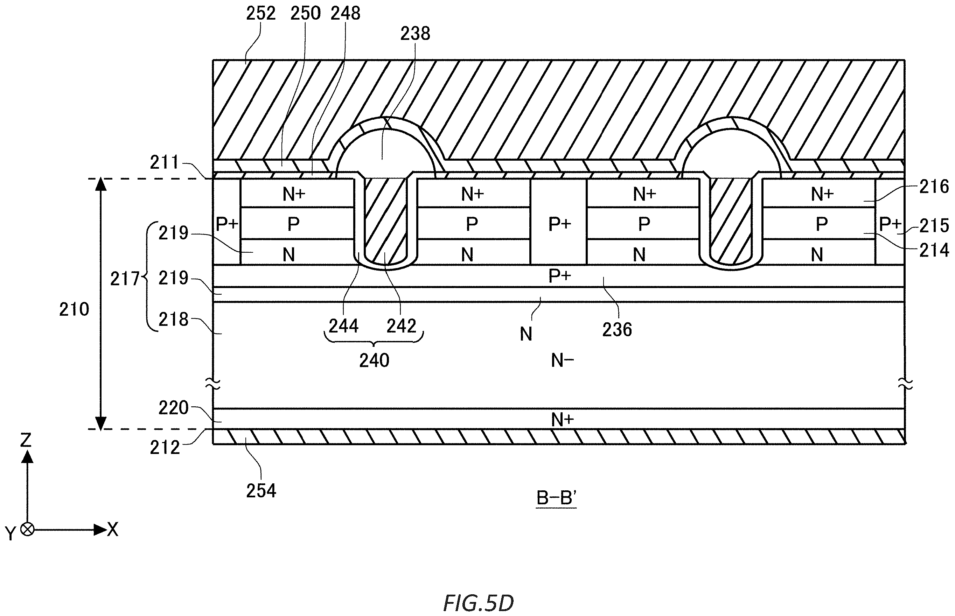

Fig. 5D shows an example of a cross section B-B' in Fig. 5A. Fig. 5D is a cross section including the third high concentration portion 236, and different from the cross section of Fig. 5C that does not include the third high concentration portion 236. The other components may be the same as those of Fig. 5C.

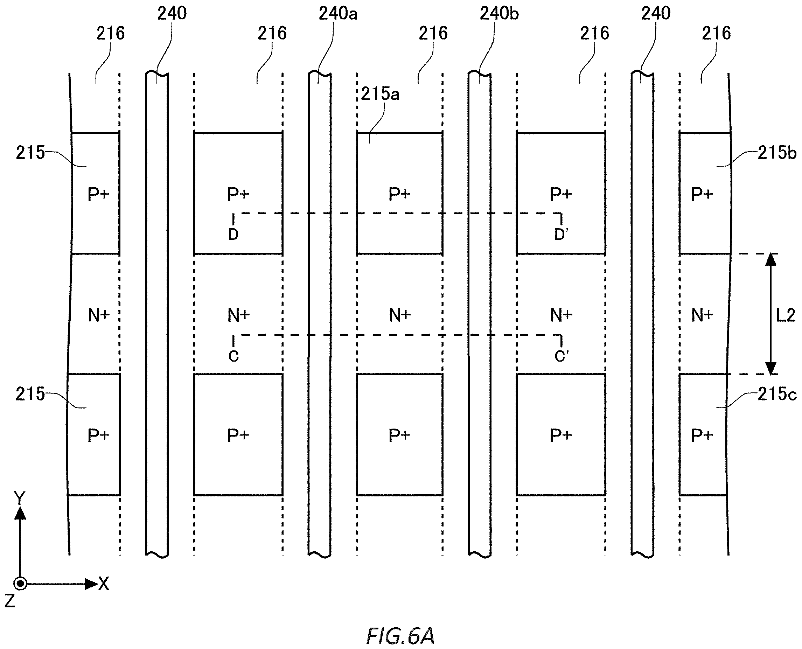

Fig. 6A shows a modified example of an upper surface of the to-be-controlled MOSFET 20. The contact region 215 of the present example is different from the example embodiment of Fig. 5A in that it is not provided to extend in the Y axis which is the extending direction of the trench portion 240. That is, the to-be-controlled MOSFET 20 of the present example includes, between adjacent trench portions 240 among the plurality of trench portions 240, a plurality of contact regions 215 of the second conductivity type that is arranged in an island shape spaced apart from each of the adjacent trench portions 240 and has a higher doping concentration than the base region 214. For example, the contact region 215a is arranged in an island shape spaced apart from each of the adjacent trench portions 240a and 240b between the adjacent trench portions 240a and 240b among the plurality of trench portions 240.

A separation distance of contact regions 215 that are adjacent in the extending direction of the plurality of trench portions 240 among the plurality of contact regions 215 may be 2 µm or more and 4 µm or less. That is, a separation distance L2 of the contact regions 215b and 215c that are adjacent in the Y axis direction that is the extending direction of the trench portion 240 among the plurality of contact regions 215 may be 2 µm or more, and 4 µm or less. As an example, the separation distance L2 is 3 µm.

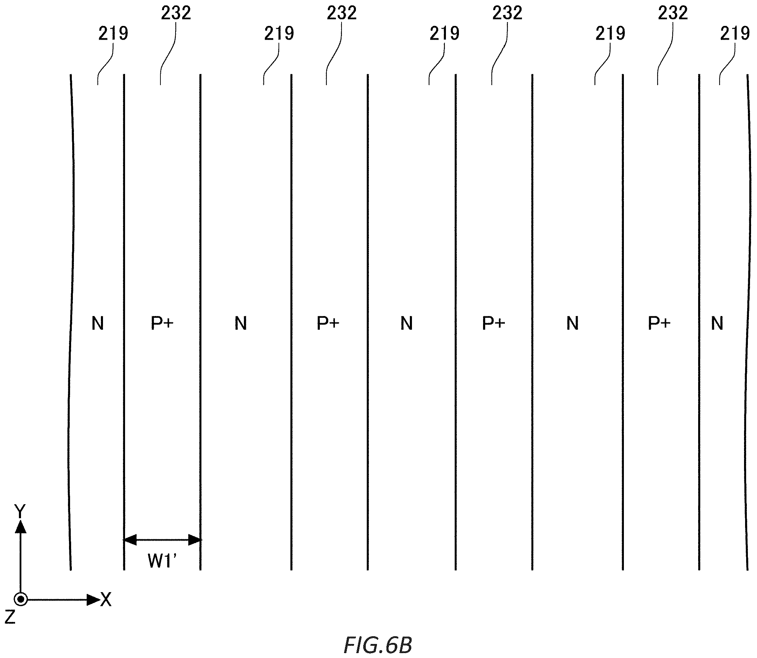

Fig. 6B shows a modified example of a cross section including a high concentration region 230 of the to-be-controlled MOSFET 20. The example of Fig. 6B is different from that of the example embodiment of Fig. 5B in that the high concentration region 230 of the present example does not include the second high concentration portion 234 and the third high concentration portion 236. That is, the high concentration region 230 of the present example includes a plurality of first high concentration portions 232 respectively extending in the extending direction, below each of the plurality of trench portions 240. The first high concentration portion 232 extends in the Y axis direction that is the extending direction of the trench portion 240.

A width W1' of the first high concentration portion 232 may be 1.0 µm or more, and 1.4 µm or less. As an example, the width W1' of the first high concentration portion 232 is 1.2 µm.

In a top view, an area proportion of the high concentration region 230 relative to an area of a drift region 217 may be less than 50%, or may be 44% or more and 48% or less. In the cross section of Fig. 6B, the area of the high concentration region 230 may be less than the area of a second drift region 219. A ratio of the area of the high concentration region 230 occupying on the area of the region shown in Fig. 6B may be less than 50%, or may be 44% or more and 48% or less.

By setting the width W1' of the first high concentration portion 232 and the separation distance L2 of the first high concentration portion 232 as described above, the area proportion of the high concentration region 230 relative to the area of the drift region 217 can be less than 50%, or can be 44% or more and 48% or less. By causing the area proportion of the high concentration region 230 relative to the area of the drift region 217 to be less than 50%, a hole injection amount during a period in which a current is flowing in the built-in diode can be suppressed. That is, by causing the area proportion of the high concentration region 230 of a second conductivity type which is a factor of hole injection to be less than 50%, a hole injection amount during a period in which a current is flowing in the built-in diode can be suppressed. If the hole injection amount during the period in which the current is flowing in the built-in diode is reduced, the frequency of recombining electrons and holes is reduced, and an expansion of stacking faults can be suppressed. Furthermore, by suppressing the expansion of the stacking faults, a rise of an on-resistance and a rise of an on-voltage of the to-be-controlled MOSFET 20 can be suppressed, and a failure of the to-be-controlled MOSFET 20 can be reduced.

That is, in response to the doping concentration of the high concentration region 230, the width W1' of the first high concentration portion 232 and the separation distance L2 of the first high concentration portion 232 may be respectively set with a value by which the hole injection amount is suppressed, or may be set in response to the doping concentration of the base region 214, the contact region 215, the source region 216, the drift region 217, or the like.

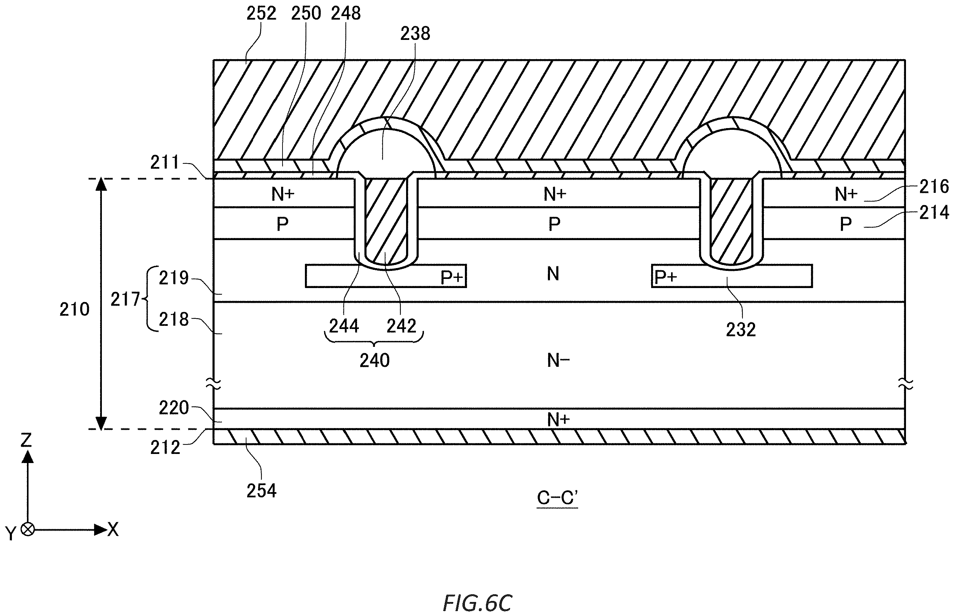

Fig. 6C shows an example of a cross section C-C' in Fig. 6A. The example of Fig. 6C is different from the example embodiment of Fig. 5C in that the contact region 215 is not provided between the adjacent trench portions 240 and in that the second high concentration portion 234 that is positioned below the contact region 215 is not provided.

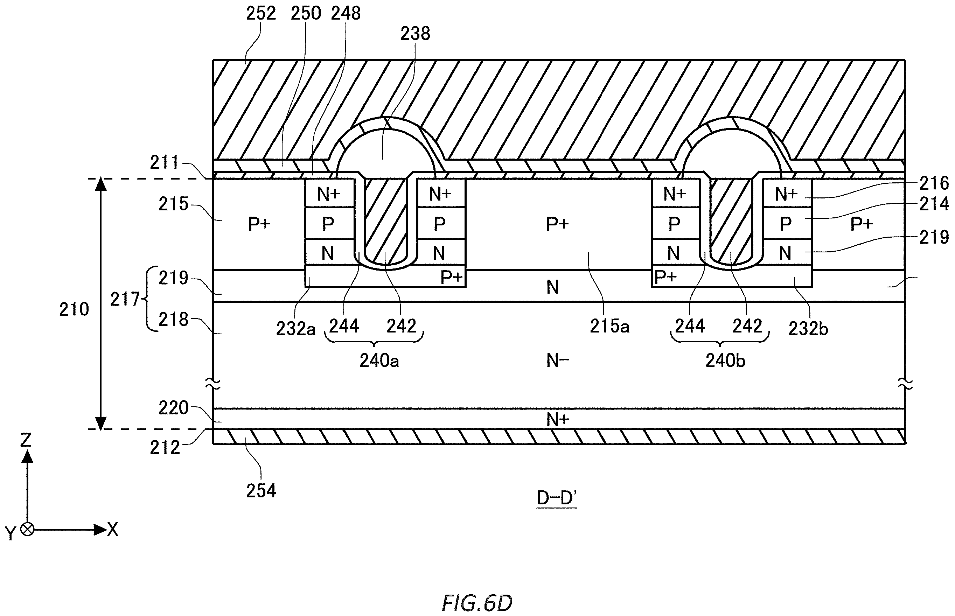

Fig. 6D shows an example of a cross section D-D' in Fig. 6A. The example of Fig. 6D is different from the example embodiment of Fig. 5D in that the second high concentration portion 234 positioned below the contact region 215 is not provided and in that the third high concentration portion 236 that traverses the first high concentration portions 232 and the second high concentration portions 234 is not provided.

In the to-be-controlled MOSFET 20 of the present example, each of the plurality of contact regions 215 is provided in contact with each of the first high concentration portion 232 provided below each of the adjacent trench portions 240 among the plurality of first high concentration portions 232. For example, the contact region 215a is provided in contact with each of the first high concentration portion 232a and 232b provided below each of the adjacent trench portions 240a and 240b among the plurality of first high concentration portions 232. The contact region 215 may be provided as a bridge for conducting the plurality of first high concentration portions 232.

In the example embodiments of Fig. 6A to Fig. 6D, the to-be-controlled MOSFET 20 can be formed with a configuration more simple compared to the example embodiments of Fig. 5A to Fig. 5D.

In addition, because the to-be-controlled MOSFET 20 can be formed with the simple configuration, the to-be-controlled MOSFET 20 can be miniaturized with its cell pitches being tightened.

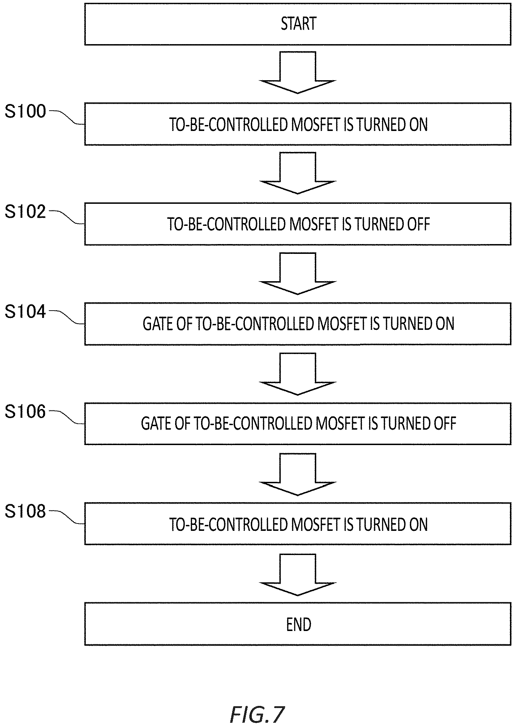

Fig. 7 shows an example of a flowchart of a control method of a silicon carbide MOSFET inverter circuit 100. The present example shows an example of a flowchart of a control method of a silicon carbide MOSFET inverter circuit 100, but not limited thereto.

In S100, a to-be-controlled MOSFET 20 is turned on. In this manner, the to-be-controlled MOSFET 20 put into a turned-on state, and this corresponds to the state before T = 0 µs in Fig. 2A.

In S102, a to-be-controlled MOSFET 20 is turned off. This step corresponds to the time point of T = 0 µs in Fig. 2A. A turn-off period of the to-be-controlled MOSFET 20 is started.

In S104, a gate of the to-be-controlled MOSFET is turned on. In this manner, a synchronization control of the to-be-controlled MOSFET 20 is started. This step corresponds to the T = 5 µs of Fig. 3. That is, in S104, during the turn-off period of the to-be-controlled MOSFET 20, the gate of the to-be-controlled MOSFET 20 may be turned on such that a saturation current period in which a transient current flowing in the built-in diode of the to-be-controlled MOSFET 20 becomes a saturation current Ic is less than 5 µs. As shown in Fig. 4, when the saturation current period is less than 5 µs, the failure of the to-be-controlled MOSFET 20 can be reduced. Accordingly, the gate of the to-be-controlled MOSFET 20 may be turned on such that the saturation current period is 2 µs, the gate of the to-be-controlled MOSFET 20 may be turned on such that the saturation current period is 3 µs, the gate of the to-be-controlled MOSFET 20 may be turned on such that the saturation current period is 4 µs, and the gate of the to-be-controlled MOSFET 20 may be turned on such that the saturation current period is less than 5 µs. In addition, during a turn-off period of the to-be-controlled MOSFET 20, the current density of the transient current flowing in the built-in diode of the to-be-controlled MOSFET 20 may be less than 1000A/cm². That is, the current density of the saturation current Ic may be less than 1000A/cm². As an example, the current density of the saturation current Ic is 900A/cm².

By performing the synchronization control on the to-be-controlled MOSFET 20, an expansion of stacking faults of the to-be-controlled MOSFET 20 can be suppressed. That is, by performing the synchronization control on the to-be-controlled MOSFET 20 to cause the saturation current period in which the transient current becomes the saturation current Ic to be less than 5 µs, the current flowing in the built-in diode during a period in which an amount of holes injected in the to-be-controlled MOSFET 20 is small can be reduced, and the frequency of recombining the electrons and the holes can be reduced to suppress the expansion of the stacking faults. Furthermore, by suppressing the expansion of the stacking faults, a rise of an on-resistance and a rise of an on-voltage of the to-be-controlled MOSFET 20 can be suppressed, and a failure of the to-be-controlled MOSFET 20 can be reduced.

In S106, a gate of the to-be-controlled MOSFET 20 is turned off. This step corresponds to the time point of T = 8 µs in Fig. 3. The synchronization control of the to-be-controlled MOSFET 20 ends.

In S108, the to-be-controlled MOSFET 20 is turned on. In this manner, the to-be-controlled MOSFET 20 is put into a turned-on state, and the turn-off period of the to-be-controlled MOSFET 20 ends. This step corresponds to the time point of T = 16.5 µs in Fig. 2A.

The to-be-controlled MOSFET 20 may be operated repeatedly by periodically repeating the step S100 to S108. That is, S100 and S108 may indicate the same step.

While the present invention has been described with the embodiments, the technical scope of the present invention is not limited to the above-described embodiments. It is apparent to persons skilled in the art that various alterations and improvements can be added to the above-described embodiments. It is also apparent from the scope of the claims that the embodiments added with such alterations or improvements can be included in the technical scope of the present invention.

The operations, procedures, steps, stages, or the like of each process performed by a device, system, program, and method shown in the claims, embodiments, or diagrams can be realized in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCES

10: direct current power source
12: smoothing capacitor
20: to-be-controlled MOSFET
21: first built-in diode
22: first silicon carbide MOSFET
23: first diode
25: second built-in diode
26: second silicon carbide MOSFET
27: second diode
30: control circuit
40: load
100: silicon carbide MOSFET inverter circuit
210: semiconductor substrate
211: front surface
212: back surface
214: base region
215: contact region
216: source region
217: drift region
218: first drift region
219: second drift region
220: buffer region
230: high concentration region
232: first high concentration portion
234: second high concentration portion
236: third high concentration portion
238: dielectric film
240: trench portion
242: gate conductive portion
244: gate dielectric film
248: contact electrode
250: barrier metal
252: source electrode
254: drain electrode.

## Claims

1. A silicon carbide MOSFET inverter circuit in which a first silicon carbide MOSFET and a second silicon carbide MOSFET are connected in series, wherein:
a current density of a transient current flowing in a built-in diode of a to-be-controlled MOSFET is less than 1000A/cm² during a turn-off period of the to-be-controlled MOSFET;
a gate of the to-be-controlled MOSFET is turned on during the turn-off period such that a saturation current period in which the transient current becomes a saturation current is less than 5 µs; and
the to-be-controlled MOSFET is the first silicon carbide MOSFET or the second silicon carbide MOSFET.

2. The silicon carbide MOSFET inverter circuit according to claim 1, wherein the to-be-controlled MOSFET includes:
a drift region of a first conductivity type provided in a silicon carbide semiconductor substrate;
a base region of a second conductivity type provided above the drift region in the semiconductor substrate; and
a high concentration region of the second conductivity type having a higher doping concentration than the base region in the semiconductor substrate, wherein
an area proportion of the high concentration region relative to an area of the drift region in a top view is less than 50%.

3. The silicon carbide MOSFET inverter circuit according to claim 2, wherein the area proportion is 44% or more and 48% or less.

4. The silicon carbide MOSFET inverter circuit according to claim 3, wherein the doping concentration of the high concentration region is 4E18cm⁻³ or more and 1E19cm⁻³ or less.

5. The silicon carbide MOSFET inverter circuit according to claim 1, wherein the to-be-controlled MOSFET includes:
a drift region of a first conductivity type provided in a silicon carbide semiconductor substrate;
a base region of a second conductivity type provided above the drift region in the semiconductor substrate;
a high concentration region of the second conductivity type having a higher doping concentration than the base region in the semiconductor substrate;
a plurality of trench portions extending in a predetermined extending direction at a front surface side of the semiconductor substrate; and
a plurality of contact regions of the second conductivity type having a higher doping concentration than the base region, respectively extending in the extending direction of the plurality of trench portions, between adjacent trench portions among the plurality of trench portions, wherein the high concentration region includes
a plurality of first high concentration portions, respectively extending in the extending direction of the plurality of trench portions, below each of the plurality of trench portions.

6. The silicon carbide MOSFET inverter circuit according to claim 5, wherein the high concentration region includes a plurality of second high concentration portions, respectively extending in the extending direction of the plurality of trench portions, below each of the plurality of contact regions.

7. The silicon carbide MOSFET inverter circuit according to claim 6, wherein the high concentration region includes a plurality of third high concentration portions extending in a stripe shape traversing the plurality of first high concentration portions and the plurality of second high concentration portions in an arrangement direction of the plurality of trench portions.

8. The silicon carbide MOSFET inverter circuit according to claim 7, wherein a separation distance between third high concentration portions that are adjacent in the extending direction of the plurality of trench portions among the plurality of third high concentration portion provided in the stripe shape is 24 µm or more and 40 µm or less.

9. The silicon carbide MOSFET inverter circuit according to claim 7, wherein an area proportion of the high concentration region relative to an area of the drift region in a top view is less than 50%.

10. The silicon carbide MOSFET inverter circuit according to claim 9, wherein the doping concentration of the high concentration region is 4E18cm⁻³ or more and 1E19cm⁻³ or less.

11. The silicon carbide MOSFET inverter circuit according to claim 1, wherein the to-be-controlled MOSFET includes:
a drift region of a first conductivity type provided in a silicon carbide semiconductor substrate;
a base region of a second conductivity type provided above the drift region in the semiconductor substrate;
a high concentration region of the second conductivity type having a higher doping concentration than the base region in the semiconductor substrate;
a plurality of trench portions extending in a predetermined extending direction at a front surface side of the semiconductor substrate; and
a plurality of contact regions of the second conductivity type having a higher doping concentration than the base region, arranged in an island shape spaced apart from each of adjacent trench portions, between the adjacent trench portions among the plurality of trench portions, wherein
the high concentration region includes a plurality of first high concentration portions, respectively extending in the extending direction, below each of the plurality of trench portions.

12. The silicon carbide MOSFET inverter circuit according to claim 11, wherein each of the plurality of contact regions is provided in contact with each of first high concentration portions provided below each of the adjacent trench portions among the plurality of first high concentration portions.

13. The silicon carbide MOSFET inverter circuit according to claim 12, wherein a separation distance between contact regions that are adjacent in the extending direction of the plurality of trench portions among the plurality of contact regions is 2 µm or more and 4 µm or less.

14. The silicon carbide MOSFET inverter circuit according to claim 12, wherein an area proportion of the high concentration region relative to an area of the drift region in a top view is less than 50%.

15. The silicon carbide MOSFET inverter circuit according to claim 14, wherein the area proportion is 44% or more and 48% or less.

16. The silicon carbide MOSFET inverter circuit according to claim 15, wherein the doping concentration of the high concentration region is 4E18cm⁻³ or more and 1E19cm⁻³ or less.

17. The silicon carbide MOSFET inverter circuit according to any one of claims 1 to 16, comprising
a first diode connected to the first silicon carbide MOSFET in an anti-parallel manner, and
a second diode connected to the second silicon carbide MOSFET in an anti-parallel manner.

18. The silicon carbide MOSFET inverter circuit according to any one of claims 1 to 16, wherein a bus voltage applied to the to-be-controlled MOSFET is 2/3 or less of a breakdown voltage of the to-be-controlled MOSFET.

19. A control method of a silicon carbide MOSFET inverter circuit in which a first silicon carbide MOSFET and a second silicon carbide MOSFET are connected in series, comprising:
turning off a to-be-controlled MOSFET; and
turning on a gate of the to-be-controlled MOSFET during a turn-off period of the to-be-controlled MOSFET such that a saturation current period in which a transient current flowing in a built-in diode of the to-be-controlled MOSFET becomes a saturation current is less than 5 µs, wherein
during the turn-off period, a current density of the transient current is less than 1000A/cm², and
the to-be-controlled MOSFET is the first silicon carbide MOSFET or the second silicon carbide MOSFET.
